# EUROPEAN PATENT APPLICATION

(11) **EP 1 631 125 A1**
(43) Date of publication of application: **01.03.2006**
(21) Application number: 04730046.2
(22) Date of filing: 28.04.2004
(51) Int. Cl.: H05B 33/22, H05B 33/14

(54) **ORGANIC ELECTROLUMINESCENT DEVICE AND DISPLAY**

(30) Priority: 20.05.2003 JP 2003141973
(71) Applicant: IDEMITSU KOSAN CO., LTD., Tokyo 100-8321 (JP)
(72) Inventor: KAWAMURA, Hisayuki, Chiba 2990293 (JP)
(74) Representative: Gille Hrabal Struck Neidlein Prop Roos
(86) International application number: PCT/JP2004/006183
(87) International publication number: WO 2004/105445

(57) **Abstract**

An organic electroluminescent device (1) including: a pair of electrodes being an anode (12) and a cathode (16), an emitting layer (14) including an organic compound, the layer being interposed between the electrodes, and charge-transporting layers (13) including an organic compound between at least one of the anode (12) and the cathode (13), and the emitting layer (14), the charge-transporting layers (13) being stacked with an inorganic compound layer (17) interposed therebetween. The organic electroluminescence device (1) can be driven with a low voltage although it is of thick thickness structure.

## Description

### Technical Field

The invention relates to an organic electroluminescent device and, particularly, an organic electroluminescent device characterized by charge-transporting layers stacked with an inorganic compound interposed therebetween.

### Background Art

Electroluminescent devices, which use electroluminescent (hereinafter referred to as EL), have a high visibility because of spontaneous emission and further have good features, such as excellent impact resistance, because they are completely solid elements. Therefore, attention has been paid to the use thereof as light emitting elements in various display devices.

Such an EL device is classified into an inorganic EL device using an inorganic compound and an organic EL device using an organic compound as a luminescent material. The organic EL device has been developed as a luminescent device of the next generation, since its voltage to be applied can be remarkably reduced, a full-color display is easily realized, it consumes a small amount of power and surface emission is possible.

The basic structure of organic EL device is anode/emitting layer/cathode. There are also known the structures containing a hole-injecting-transporting layer and/or electron-injecting layer, for example, anode/hole-injecting-transporting layer/emitting layer/cathode, anode/hole-injecting-transporting layer/emitting layer/electron-injecting layer/cathode.

The hole-injecting-transporting layer injects holes from an anode and transports them to an organic emitting layer. A hole-injecting layer and hole-transporting layer may be separately made. The electron-injecting layer injects electrons from a cathode and transports them to an organic emitting layer. The organic emitting layer receives holes and electrons thus injected, and emits light by re-combination of holes and electrons.

An organic EL device has an ultra thin film held between electrodes, the thickness of the film being as thin as 100 to 1000 nm. Thus such an organic EL device can emit light with a high luminance at a voltage as low as several volts to several tens volts.

However the ultra thin film is liable to be affected by extremely fine projections in a substrate and electrode, resulting in short circuit and pixel defects, which is a serious practical problem.

In order to avoid the problem, it is known to make the thickness of an organic compound layer held between electrodes thicker. However in this method, a driving voltage disadvantageously increases. There is then disclosed technique for making an organic EL device thicker without an increase in voltage.

For example, the following technique is disclosed in "Thick organic EL device driven with low voltage," Akio Taniguchi, M&BE, Vol.10, No.1 (1999), p20-28. An amine compound is dispersed and an oxide is doped in a polymer. The polymer thus obtained is applied to form a hole-transporting layer of an organic EL device.

However, for such an applying method, it is known that a solvent remains in a thin film and the solvent reacts with an electrode of an organic EL device, resulting in defects.

There is another method of forming a hole-transporting layer by co-depositing an oxide and amine compound (for example, JP-A-2000-315580) .

However an oxidizable dopant often diffuses when a device is driven and affects an emitting layer so that an organic EL device with a long durability cannot be obtained.

In view of the above problem, an object of the invention is to provide an organic EL device that can be driven with a low voltage although it is of thick-thickness structure.

### Disclosure of the Invention

To solve the above subject, the inventors have found that an organic EL device of thick-thickness structure can be driven with a low voltage by laminating electron-transporting layers with an inorganic compound layer therebetween and made the invention.

The invention provides the following EL devices.
1. An organic EL device comprising: a pair of electrodes being an anode and a cathode, an emitting layer comprising an organic compound, the layer being interposed between the electrodes, and charge-transporting layers comprising an organic compound between at least one of the anode and the cathode, and the emitting layer, the charge-transporting layers being stacked with an inorganic compound layer interposed therebetween.
2. The organic EL device according to 1, wherein hole-transporting layers exist as the charge-transporting layer between the anode and the emitting layer, and the hole-transporting layers are stacked with the inorganic compound layer interposed therebetween.
3. The organic EL device according to 1, wherein electron-transporting layers exist as the charge-transporting layer between the cathode and the emitting layer, and the electron-transporting layers are stacked with the inorganic compound layer interposed therebetween.
4. The organic EL device according to any one of 1 to 3, wherein the inorganic compound layer comprises at least one of elements belonging to the third group to the twelfth group of the periodic system.
5. The organic EL device according to 4, wherein the inorganic compound layer between hole-transporting layers further comprises at least one of elements belonging to the first group or the second group of the periodic system.
6. A display comprising a display screen formed by comprising the organic EL device according to any one of 1 to 5.

Combined with known constructions, the organic EL device of the invention can be used for screens of various display equipment such as consumer TVs, large displays, and displays for cellular phones.

### Brief Description of the Drawings

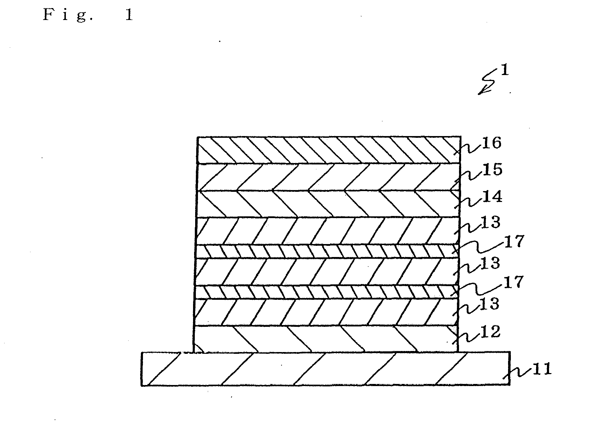

Fig. 1 is a sectional view of an organic EL device that is an embodiment of the invention.

### Best Modes for Carrying Out the Invention

The invention is described in detail hereinafter.

An organic EL device of the invention comprises at least a pair of electrodes and an emitting layer comprising an organic compound, the layer being held between the electrodes. It has charge-transporting layers comprising an organic compound between at least one of the electrodes and the emitting layer. The charge-transporting layers are stacked with an inorganic compound layer interposed therebetween.

The charge-transporting layer means a layer made of an organic compound that transports holes or electrons from an electrode to an emitting layer, e.g., a hole-transporting layer, hole-injecting layer, electron-transporting layer, and electron-injecting layer.

Fig.1 is a sectional view of an organic EL device according to an embodiment of the invention.

An organic EL device 1 is constructed such that an anode 12, hole-transporting layers (charge-transporting layer) 13, emitting layer 14, electron-transporting layer (charge-transporting layer) 15 and cathode 16 are sequentially stacked on a substrate 11. The hole-transporting layers 13 are stacked with inorganic compound layers 17 interposed therebetween.

The substrate 11 supports the organic EL device. The anode 12 injects holes into the hole-transporting layer 13 or emitting layer 14. The hole-transporting layers 13 aid the injection of holes into the emitting layer 14 and transports holes to an emitting region. The cathode 16 injects electrons into the electron-transporting layer 15 or emitting layer 14. The electron-transporting layer 15 aids the injection of electrons into the emitting layer 14. The emitting layer 14 mainly provides a site where electrons recombine with holes for light emission.

In the organic EL device 1, the hole-transporting layers 13 are stacked with the inorganic compound layers 17 therebetween.

The thick thickness of a hole-transporting layer that is a charge-transporting layer prevents short circuit and pixel defects of an organic EL device. However in a conventional single hole-transporting layer, the driving voltage of an organic EL device rapidly increases as the thickness of hole-transporting layer increases. There is then a limit to the thick thickness of a hole-transporting layer.

The lamination of hole-transporting layers 13 with the inorganic compound layers 17 therebetween according to the invention can suppress an increase in driving voltage caused by an increase in thickness of a hole-transporting layer 13. Thus the hole-transporting layers of the invention can be thicker than a hole-transporting layer 13 (single layer), thereby effectively preventing short circuit and pixel defects.

In this embodiment, only the hole-transporting layers 13 are stacked with the inorganic compound layers 17 therebetween, but both the hole-transporting layers 13 and the electron-transporting layer 15 may be of the stacked structure or only the electron-transporting layer 15 may be of the lamination structure.

In this embodiment, the hole-transporting layers 13 stacked are three layers but the number of hole-transporting layers is not limited to these. Two to ten layers of hole-transporting layers 13 are preferably stacked. The hole-transporting layers 13 may be the same as or different from each other.

Also the inorganic compound layers 17 stacked are two layers but the number of inorganic compound layers is not limited to these. One to nine layers of inorganic compound layers 17 are preferably stacked.

When the inorganic compound layers 17 are two or more layers, they may be the same as or different from each other.

The inorganic compound layers 17 may have a film thickness of several nm to several tens nm, specifically 1 to 20 nm, preferably 1 to 10 nm.

The hole-transporting layers 13 may have a thickness of 5 nm to 5 µm, preferably 5 nm to 100 nm.

When the electron-transporting layer 15 is made in the lamination structure with the inorganic compound layers 17 therebetween, its thickness and numbers of stacked layers are preferably the same as those of the hole-transporting layers 13.

The inorganic compound layer of the invention preferably contains at least one element selected from the third to twelfth groups of the periodical table.

The periodical table of the present specification means the long periodical type periodical table.

Specific examples thereof include oxides, sulfides, chalcogenides, halides, nitrides, and phosphides of Ti, V, Cr, Mn, Fe, Co, Ni, Cu, Zn, Y, Zr, Nb, Mo, Ru, Rh, Pd, Ag, Cd, Hf, Ta, W, Re, Ir and Pt.

Preferred are vanadium oxide, manganese oxide, nickel oxide, molybdenum oxide, tungsten oxide, iridium oxide, cadmium sulfide, molybdenum sulfide, zinc sulfide, copper iodide and silver bromide.

These inorganic compounds can be used individually or as a combination of two or more compounds.

The inorganic compound layer more preferably contains at least one element selected from the first to second groups of the periodical table.

Specific examples thereof include Li, Na, Mg, K, Ca, Rb, Sr, Cs, Ba and oxides, sulfides, chalcogenides, halides, nitrides and phosphides thereof.

Preferred are lithium, lithium fluoride, lithium oxide, sodium, sodium fluoride, sodium chloride, magnesium fluoride, magnesium oxide, calcium, cesium, cesium oxide, cesium fluoride, cesium iodide, barium oxide and barium chloride.

These inorganic compounds can be used individually or as a combination of two or more compounds.

The structure and each component of the organic EL device are described in detail below.

### (1) Structure of Organic EL Device

The organic EL device may have the following structures:
(a) anode/hole-transporting zone/emitting layer/cathode
(b) anode/emitting layer/electron-transporting zone/cathode
(c) anode/hole-transporting zone/ emitting layer/electron-transporting zone/cathode
(d) anode/hole-transporting zone/ emitting layer/adhesion-remediation layer /cathode
(e) anode/insulating layer/hole-transporting zone/ emitting layer/electron-transporting zone/cathode
(f) anode/hole-transporting zone/emitting layer/electron-transporting zone/insulating layer/cathode
(g) anode/inorganic semiconductor layer/insulating layer/hole-transporting zone/emitting layer/insulating layer /cathode
(h) anode/insulating layer/hole-transporting zone/emitting layer/ electron-transporting zone/insulating layer /cathode, etc.

They are formed on a substrate.

Among these, (c), (e) and (f) are generally preferably used.

The invention is not limited to these.

The hole-transporting zone contains at least one hole-transporting layer or a laminate of hole-transporting layers with an inorganic compound layer mentioned therebetween and, if necessary, a hole-injecting layer and the like.

The electron-transporting zone contains at least one electron-transporting layer or a laminate of electron-transporting layers with an inorganic compound layer mentioned therebetween and, if necessary, an electron-transporting layer and the like.

### (2) Translucent Substrate

The organic EL device of the invention is formed on a translucent substrate. The translucent substrate for supporting an organic EL device preferably has a light transmittance of 50% or more in the visible region of 400 to 700 nm and is preferably smooth.

Specifically, it can be a glass plate, a polymer plate and the like. Examples of the glass plate include soda lime glasses, barium/strontium-containing glasses, flint glasses, alumnosilicate glasses, borosilicate glasses, barium borosilicate glasses and quartzes. Examples of the polymer plate are polycarbonates, acrylics, polyethylene terephthalates, polyether sulfides and polysulfones.

The above structure is applied to elements which take light emitted in an emitting layer out from the substrate side; however, light can also be taken out from the side opposite to the substrate. In this case, the substrate does not have to be translucent.

### (3) Anode

An anode of an organic thin film EL device functions to inject holes to a hole-transporting layer or an emitting layer and it effectively has a work function of 4.5 eV or more.

As specific examples of anode materials used for the invention, indium oxide-tin alloys (ITO), tin oxides (NESA), gold, silver, platinum, copper and the like can be applied.

An anode can be formed by forming a thin film from these electrode materials by vacuum deposition, sputtering and the like.

In case of taking light emitted by an emitting layer out from an anode, the anode preferably has a transmittance against the emitted light of larger than 10%. It preferably has a sheet resistance of some hundreds Ω/ or less. Its thickness, depending on material thereof, is usually 10 nm to 1 µm, preferably 10 to 200 nm.

### (4) Emitting Layer

An emitting layer of an organic EL device possesses the following functions:
(a) an injection function; which enables to inject holes from an anode or hole-injecting layer and to inject electrons from a cathode or electron-injecting layer, when an electric field is impressed,
(b) a transport function; which transports injected electric charge (electrons and holes) with electric fields' power, and
(c) an emitting function; which provides a re-combination site for electrons and holes to emit light.

There may be a difference in ease of injection between holes and electrons, and also a difference in transport capacity that is represented by mobilities of holes and electrons. However, moving one of the electric charges is preferred.

As methods of forming this emitting layer, known methods such as vacuum deposition, spin coating and LB technique can be applied. An emitting layer is particularly preferably a molecule-deposited film.

The term "molecule-deposited film" here means a thin film that is formed by depositing a material compound in a vapor phase and a film formed by solidifying a material compound in a solution state or liquid state. Usually this molecular deposition film can be distinguished from a thin film formed by the LB technique (a molecule-accumulated film) by differences in agglutination structure and higher dimension structure, and functional differences caused by these.

As disclosed in JP-A-57-51781, an emitting layer can also be formed by dissolving a binder such as resins and material compound in a solvent to make a solution and forming a thin film therefrom by spin coating and so on.

The material used in emitting layers may be a material known as a luminescent material having a long durability. It is preferred to use, as the material of the luminescent material, a material represented by the formula [1]: 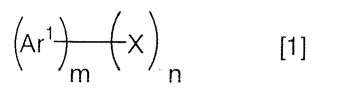 wherein Ar¹ is an aromatic ring with 6 to 50 nucleus carbon atoms, X¹ is a substituent, m is integer of 1 to 5, and n is an integer of 0 to 6, provided that Ar¹s may be the same as or different from each other when m is 2 or more, and X¹s may be the same as or different from each other when n is 2 or more. Preferably, m is 1 to 2 and n is 0 to 4.

Specific examples of Ar¹ include phenyl, naphthyl, anthracene, biphenylene, azulene, acenaphthylene, fluorene, phenanthrene, fluoranthene, acephenanthrylene, triphenylene, pyrene, chrysene, naphthacene, picene, perylene, penthaphene, pentacene, tetraphenylene, hexaphene, hexacene, rubicene, coronene, and trinaphthylene rigns.

Preferred examples thereof include phenyl, naphthyl, anthracene, acenaphthylene, fluorene, phenanthrene, fluoranthene, triphenylene, pyrene, chrysene, perylene, and trinaphthylene rings.

More preferred examples thereof include phenyl, naphthyl, anthracene, fluorene, phenanthrene, fluoranthene, pyrene, chrysene, and perylene rings.

Specific examples of X¹ include substituted or unsubstituted aromatic groups with 6 to 50 nucleus carbon atoms, substituted or unsubstituted aromatic heterocyclic groups with 5 to 50 nucleus carbon atoms, substituted or unsubstituted alkyl groups with 1 to 50 carbon atoms, substituted or unsubstituted alkoxy groups with 1 to 50 carbon atoms, substituted or unsubstituted aralkyl groups with 1 to 50 carbon atoms, substituted or unsubstituted aryloxy groups with 5 to 50 nucleus atoms, substituted or unsubstituted arylthio groups with 5 to 50 nucleus atoms, substituted or unsubstituted carboxyl groups with 1 to 50 carbon atoms, substituted or unsubstituted styryl groups, halogen groups, a cyano group, a nitro group, and a hydroxyl group. Examples of the substituted or unsubstituted aromatic groups with 6 to 50 nucleus carbon atoms include phenyl, 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 1-naphthacernyl, 2-naphthacenyl, 9-naphthacenyl, 1-pyrenyl, 2-pyrenyl, 4-pyrenyl, 2-biphenylyl, 3-biphenylyl, 4-biphenylyl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-t-butylphenyl, p-(2-phenylpropyl)phenyl, 3-methyl-2-naphthyl, 4-methyl-1-naphthyl, 4-methyl-1-anthryl, 4'-methylbiphenylyl, 4"-t-butyl-p-terphenyl-4-yl, 2-fluorenyl, 9,9-dimethyl-2-fluorenyl and 3-fluorantenyl groups.

Preferred examples thereof include phenyl, 1-naphthyl, 2-naphthyl, 9-phenanthryl, 1-naphthacenyl, 2-naphthacenyl, 9-naphthacenyl, 1-pyrenyl, 2-pyrenyl, 4-pyrenyl, 2-biphenylyl, 3-biphenylyl, 4-biphenylyl, o-tolyl, m-tolyl, p-tolyl, p-t-butylphenyl, 2-fluorenyl, 9,9-dimethyl-2-fluorenyl and 3-fluorantenyl groups.

Examples of the substituted or unsubstituted aromatic heterocyclic groups with 5 to 50 nucleus carbon atoms include 1-pyrrolyl, 2-pyrrolyl, 3-pyrrolyl, pyrazinyl, 2-pyridinyl, 3-pyridinyl, 4-pyridinyl, 1-indolyl, 2-indolyl, 3-indolyl, 4-indolyl, 5-indolyl, 6-indolyl, 7-indolyl, 1-isoindolyl, 2-isoindolyl, 3-isoindolyl, 4-isoindolyl, 5-isoindolyl, 6-isoindolyl, 7-isoindolyl, 2-furyl, 3-furyl, 2-benzofuranyl, 3-benzofuranyl, 4-benzofuranyl, 5-benzofuranyl, 6-benzofuranyl, 7-benzofuranyl, 1-isobenzofuranyl, 3-isobenzofuranyl, 4-isobenzofuranyl, 5-isobenzofuranyl, 6-isobenzofuranyl, 7-isobenzofuranyl, quinolyl, 3-quinolyl, 4-quinolyl, 5-quinolyl, 6-quinolyl, 7-quinolyl, 8-quinolyl, 1-isoquinolyl, 3-isoquinolyl, 4-isoquinolyl, 5-isoquinolyl, 6-isoquinolyl, 7-isoquinolyl, 8-isoquinolyl, 2-quinoxalinyl, 5-quinoxalinyl, 6-quinoxalinyl, 1-carbazolyl, 2-carbazolyl, 3-carbazolyl, 4-carbazolyl, 9-carbazolyl, 1-phenanthrydinyl, 2-phenanthrydinyl, 3-phenanthrydinyl, 4-phenanthrydinyl, 6-phenanthrydinyl, 7-phenanthrydinyl, 8-phenanthrydinyl, 9-phenanthrydinyl, 10-phenanthrydinyl, 1-acrydinyl, 2-acrydinyl, 3-acrydinyl, 4-acrydinyl, 9-acrydinyl, 1,7-phenanthroline-2-yl, 1,7-phenanthroline-3-yl, 1,7-phenanthroline-4-yl, 1,7-phenanthroline-5-yl, 1,7-phenanthroline-6-yl, 1,7-phenanthroline-8-yl, 1,7-phenanthroline-9-yl, 1,7-phenanthroline-10-yl, 1,8-phenanthroline-2-yl, 1,8-phenanthroline-3-yl, 1,8-phenanthroline-4-yl, 1,8-phenanthroline-5-yl, 1,8-phenanthroline-6-yl, 1,8-phenanthroline-7-yl, 1,8-phenanthroline-9-yl, 1,8-phenanthroline-10-yl, 1,9-phenanthroline-2-yl, 1,9-phenanthroline-3-yl, 1,9-phenanthroline-4-yl, 1,9-phenanthroline-5-yl, 1,9-phenanthroline-6-yl, 1,9-phenanthroline-7-yl, 1,9-phenanthroline-8-yl, 1,9-phenanthroline-10-yl, 1,10-phenanthroline-2-yl, 1,10-phenanthroline-3-yl, 1,10-phenanthroline-4-yl, 1,10-phenanthroline-5-yl, 2,9-phenanthroline-1-yl, 2,9-phenanthroline-3-yl, 2,9-phenanthroline-4-yl, 2,9-phenanthroline-5-yl, 2,9-phenanthroline-6-yl, 2,9-phenanthroline-7-yl, 2,9-phenanthroline-8-yl, 2,9-phenanthroline-10-yl, 2,8-phenanthroline-1-yl, 2,8-phenanthroline-3-yl, 2,8-phenanthroline-4-yl, 2,8-phenanthroline-5-yl, 2,8-phenanthroline-6-yl, 2,8-phenanthroline-7-yl, 2,8-phenanthroline-9-yl, 2,8-phenanthroline-10-yl, 2,7-phenanthroline-1-yl, 2,7-phenanthroline-3-yl, 2,7-phenanthroline-4-yl, 2,7-phenanthroline-5-yl, 2,7-phenanthroline-6-yl, 2,7-phenanthroline-8-yl, 2,7-phenanthroline-9-yl, 2,7-phenanthroline-10-yl, 1-phenazinyl, 2-phenazinyl, 1-phenothiazinyl, 2-phenothiazinyl, 3-phenothiazinyl, 4-phenothiazinyl, 10-phenothiazinyl, 1-phenoxazinyl, 2-phenoxazinyl, 3-phenoxazinyl, 4-phenoxazinyl, 10-phenoxazinyl, 2-oxazolyl, 4-oxazolyl, 5-oxazolyl, 2-oxadiazolyl, 5-oxadiazolyl, 3-furazanyl, 2-thienyl, 3-thienyl, 2-methylpyrrole-1-yl, 2-methylpyrrole-3-yl, 2-methylpyrrole-4-yl, 2-methylpyrrole-5-yl, 3-methylpyrrole-1-yl, 3-methylpyrrole-2-yl, 3-methylpyrrole-4-yl, 3-methylpyrrole-5-yl, 2-t-butylpyrrole-4-yl, 3-(2-phenylpropyl)pyrrole-1-yl, 2-methyl-1-indolyl, 4-methyl-1-indolyl, 2-methyl-3-indolyl, 4-methyl-3-indolyl, 2-t-butyl 1-indolyl, 4-t-butyl 1-indolyl, 2-t-butyl 3-indolyl, and 4-t-butyl 3-indolyl groups.

Examples of the substituted or unsubstituted alkyl groups with 1 to 50 carbon atoms include methyl, ethyl, propyl, isopropyl, n-butyl, s-butyl, isobutyl, t-butyl, n-pentyl, n-hexyl, n-heptyl, n-octyl, hydroxymethyl, 1-hydroxyethyl, 2-hydroxyethyl, 2-hydroxyisobutyl, 1,2-dihydroxyethyl, 1,3-dihydroxyisopropyl, 2,3-dihydroxy-t-butyl, 1,2,3-trihydroxypropyl, chloromethyl, 1-chloroethyl, 2-chloroethyl, 2-chloroisobutyl, 1,2-dichloroethyl, 1,3-dichloroisopropyl, 2,3-dichloro-t-butyl, 1,2,3-trichloropropyl, nitromethyl, 1-nitroethyl, 2-nitroethyl, 2-nitroisobutyl, 1,2-dinitroethyl, 1,3-dinitroisopropyl, 2,3-dinitro-t-butyl, 1,2,3-trinitropropyl, cyclopropyl, cyclobutyl, cyclopentyl, cyclohexyl, 4-methylcyclohexyl, 1-adamanthyl, 2-adamanthyl, 1-norbornyl, and 2-norbornyl groups.

The substituted or unsubstituted alkoxy groups with 1 to 50 carbon atoms are groups represented by -OY. Examples of Y include methyl, ethyl, propyl, isopropyl, n-butyl, s-butyl, isobutyl, t-butyl, n-pentyl, n-hexyl, n-heptyl, n-octyl, hydroxymethyl, 1-hydroxyethyl, 2-hydroxyethyl, 2-hydroxyisobutyl, 2,3-dihyroxy-t-butyl, 1,2,3-trihydroxypropyl, chloromethyl, 1-chloroethyl, 2-chloroethyl, 2-chloroisobutyl, 1,2-dichloroethyl, 1,3-dichloroisopropyl, 2,3-dichloro-t-butyl, 1,2,3-trichloropropyl, bromomethyl, 1-bromoethyl, 2-bromoethyl, 2-bromoisobutyl, 1,2-dibromoethyl, 1,3-dibromoisopropyl, 2,3-dibromo-t-butyl, 1,2,3-tribromopropyl, iodomethyl, 1-iodoethyl, 2-iodoethyl, 2-iodoisobutyl, 1,2-diiodoethyl, 1,3-diiodoisopropyl, 2,3-diiodo-t-butyl, 1,2,3-triiodopropyl, aminomethyl, 1-aminoethyl, 2-aminoethyl, 2-aminoisobutyl, 1,2-diaminoethyl, 1,3-diaminoisopropyl, 2,3-diamino-t-butyl, 1,2,3-triaminopropyl, cyanomethyl, 1-cyanoethyl, 2-cyanoethyl, 2-cyanoisobutyl, 1,2-dicyanoethyl, 1,3-dicyanoisopropyl, 2,3-dicyano-t-butyl, 1,2,3-tricyanopropyl, nitromethyl, 1-nitroethyl, 2-nitroethyl, 2-nitroisobutyl, 1,2-dinitroethyl, 1,3-dinitroisopropyl, 2,3-dinitro-t-butyl, and 1,2,3-trinitropropyl groups.

Examples of the substituted or unsubstituted aralkyl groups with 1 to 50 carbon atoms include benzyl, 1-phenylethyl, 2-phenylethyl, 1-phenylisopropyl, 2-phenylisopropyl, phenyl-t-butyl, α-naphthylmethyl, 1-α-naphthylethyl, 2-α-naphthylethyl, 1-α-naphthylisopropyl, 2-α-naphthylisopropyl, β-naphthylmethyl, 1-β-naphthylethyl, 2-β-naphthylethyl, 1-β-naphthylisopropyl, 2-β-naphthylisopropyl, 1-pyrrolylmethyl, 2-(1-pyrrolyl)ethyl, p-methylbenzyl, m-methylbenzyl, o-methylbenzyl, p-chlorobenzyl, m-chlorobenzyl, o-chlorobenzyl, p-bromobenzyl, m-bromobenzyl, o-bromobenzyl, p-iodobenzyl, m-iodobenzyl, o-iodobenzyl, p-hydroxybenzyl, m-hydroxybenzyl, o-hydroxybenzyl, p-aminobenzyl, m-aminobenzyl, o-aminobenzyl, p-nitrobenzyl, m-nitrobenzyl, o-nitrobenzyl, p-cyanobenzyl, m-cyanobenzyl, o-cyanobenzyl, 1-hydroxy-2-phenylisopropyl, and 1-chloro-2-phenylisopropyl groups.

The substituted or unsubstituted aryloxy groups with 5 to 50 nucleus atoms are represented by -OY'. Examples of Y' include phenyl, 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 1-naphthacenyl, 2-naphthacenyl, 9-naphthacenyl, 1-pyrenyl, 2-pyrenyl, 4-pyrenyl, 2-biphenylyl, 3-biphenylyl, 4-biphenylyl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-t-butylphenyl, p-(2-phenylpropyl)phenyl, 3-methyl-2-naphthyl, 4-methyl-1-naphthyl, 4-methyl-1-anthryl, 4'-methylbiphenylyl, 4"-t-butyl-p-terphenyl-4-yl, 2-pyrrolyl, 3-pyrrolyl, pyrazinyl, 2-pyridinyl, 3-pyridinyl, 4-pyridinyl, 2-indolyl, 3-indolyl, 4-indolyl, 5-indolyl, 6-indolyl, 7-indolyl, 1-isoindolyl, 3-isoindolyl, 4-isoindolyl, 5-isoindolyl, 6-isoindolyl, 7-isoindolyl, 2-furyl, 3-furyl, 2-benzofuranyl, 3-benzofuranyl, 4-benzofuranyl, 5-benzofuranyl, 6-benzofuranyl, 7-benzofuranyl, 1-isobenzofuranyl, 3-isobenzofuranyl, 4-isobenzofuranyl, 5-isobenzofuranyl, 6-isobenzofuranyl, 7-isobenzofuranyl, 2-quinolyl, 3-quinolyl, 4-quinolyl, 5-quinolyl, 6-quinolyl, 7-quinolyl, 8-quinolyl, 1-isoquinolyl, 3-isoquinolyl, 4-isoquinolyl, 5-isoquinolyl, 6-isoquinolyl, 7-isoquinolyl, 8-isoquinolyl, 2-quinoxalinyl, 5-quinoxalinyl, 6-quinoxalinyl, 1-carbazolyl, 2-carbazolyl, 3-carbazolyl, 4-carbazolyl, 1-phenanthrydinyl, 2-phenanthrydinyl, 3-phenanthrydinyl, 4-phenanthrydinyl, 6-phenanthrydinyl, 7-phenanthrydinyl, 8-phenanthrydinyl, 9-phenanthrydinyl, 10-phenanthrydinyl, 1-acrydinyl, 2-acrydinyl, 3-acrydinyl, 4-acrydinyl, 9-acrydinyl, 1,7-phenanthroline-2-yl, 1,7-phenanthroline-3-yl, 1,7-phenanthroline-4-yl, 1,7-phenanthroline-5-yl, 1,7-phenanthroline-6-yl, 1,7-phenanthroline-8-yl, 1,7-phenanthroline-9-yl, 1,7-phenanthroline-10-yl, 1,8-phenanthroline-2-yl, 1,8-phenanthroline-3-yl-, 1,8-phenanthroline-4-yl, 1,8-phenanthroline-5-yl, 1,8-phenanthroline-6-yl, 1,8-phenanthroline-7-yl, 1,8-phenanthroline-9-yl, 1,8-phenanthroline-10-yl, 1,9-phenanthroline-2,-yl, 1,9-phenanthroline-3-yl, 1,9-phenanthroline-4-yl, 1,9-phenanthroline-5-yl, 1,9-phenanthroline-6-yl, 1,9-phenanthroline-7-yl, 1,9-phenanthroline-8-yl, 1,9-phenanthroline-10-yl, 1,10-phenanthroline-2-yl, 1,10-phenanthroline-3-yl, 1,10-phenanthroline-4-yl, 1,10-phenanthroline-5-yl, 2,9-phenanthroline-1-yl, 2,9-phenanthroline-3-yl, 2,9-phenanthroline-4-yl, 2,9-phenanthroline-5-yl, 2,9-phenanthroline-6-yl, 2,9-phenanthroline-7-yl, 2,9-phenanthroline-8-yl, 2,9-phenanthroline-10-yl, 2,8-phenanthroline-1-yl, 2,8-phenanthroline-3-yl, 2,8-phenanthroline-4-yl, 2,8-phenanthroline-5-yl, 2,8-phenanthroline-6-yl, 2,8-phenanthroline-7-yl, 2,8-phenanthroline-9-yl, 2,8-phenanthroline-10-yl, 2,7-phenanthroline-1-yl, 2,7-phenanthroline-3-yl, 2,7-phenanthroline-4-yl, 2,7-phenanthroline-5-yl, 2,7-phenanthroline-6-yl, 2,7-phenanthroline-8-yl, 2,7-phenanthroline-9-yl, 2,7-phenanthroline-10-yl, 1-phenazinyl, 2-phenazinyl, 1-phenothiazinyl, 2-phenothiazinyl, 3-phenothiazinyl, 4-phenothiazinyl, 1-phenoxazinyl, 2-phenoxazinyl, 3-phenoxazinyl, 4-phenoxazinyl, 2-oxazolyl, 4-oxazolyl, 5-oxazolyl, 2-oxadiazolyl, 5-oxadiazolyl, 3-furazanyl, 2-thienyl, 3-thienyl, 2-methylpyrrole-1-yl, 2-methylpyrrole-3-yl, 2-methylpyrrole-4-yl, 2-methylpyrrole-5-yl, 3-methylpyrrole-1-yl, 3-methylpyrrole-2-yl, 3-methylpyrrole-4-yl, 3-methylpyrrole-5-yl, 2-t-butylpyrrole-4-yl, 3-(2-phenylpropyl)pyrrole-1-yl, 2-methyl-1-indolyl, 4-methyl-1-indolyl, 2-methyl-3-indolyl, 4-methyl-3-indolyl, 2-t-butyl 1-indolyl, 4-t-butyl 1-indolyl, 2-t-butyl 3-indolyl, and 4-t-butyl 3-indolyl groups.

The substituted or unsubstituted arylthio groups with 5 to 50 nucleus atoms are represented by -SY", and examples of Y" include phenyl, 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 1-naphthacenyl, 2-naphthacenyl, 9-naphthacenyl, 1-pyrenyl, 2-pyrenyl, 4-pyrenyl, 2-biphenylyl, 3-biphenylyl, 4-biphenylyl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-t-butylphenyl, p-(2-phenylpropyl)phenyl, 3-methyl-2-naphthyl, 4-methyl-1-naphthyl, 4-methyl-1-anthryl, 4'-methylbiphenylyl, 4"-t-butyl-p-terphenyl-4-yl, 2-pyrrolyl, 3-pyrrolyl, pyrazinyl, 2-pyridinyl, 3-pyridinyl, 4-pyridinyl, 2-indolyl, 3-indolyl, 4-indolyl, 5-indolyl, 6-indolyl, 7-indolyl, 1-isoindolyl, 3-isoindolyl, 4-isoindolyl, 5-isoindolyl, 6-isoindolyl, 7-isoindolyl, 2-furyl, 3-furyl, 2-benzofuranyl, 3-benzofuranyl, 4-benzofuranyl, 5-benzofuranyl, 6-benzofuranyl, 7-benzofuranyl, 1-isobenzofuranyl, 3-isobenzofuranyl, 4-isobenzofuranyl, 5-isobenzofuranyl, 6-isobenzofuranyl, 7-isobenzofuranyl, 2-quinolyl, 3-quinolyl, 4-quinolyl, 5-quinolyl, 6-quinolyl, 7-quinolyl, 8-quinolyl, 1-isoquinolyl, 3-isoquinolyl, 4-isoquinolyl, 5-isoquinolyl, 6-isoquinolyl, 7-isoquinolyl, 8-isoquinolyl, 2-quinoxalinyl, 5-quinoxalinyl, 6-quinoxalinyl, 1-carbazolyl, 2-carbazolyl, 3-carbazolyl, 4-carbazolyl, 1-phenanthrydinyl, 2-phenanthrydinyl, 3-phenanthrydinyl, 4-phenanthrydinyl, 6-phenanthrydinyl, 7-phenanthrydinyl, 8-phenanthrydinyl, 9-phenanthrydinyl, 10-phenanthrydinyl, 1-acrydinyl, 2-acrydinyl, 3-acrydinyl, 4-acrydinyl, 9-acrydinyl, 1,7-phenanthroline-2-yl, 1,7-phenanthroline-3-yl, 1,7-phenanthroline-4-yl, 1,7-phenanthroline-5-yl, 1,7-phenanthroline-6-yl, 1,7-phenanthroline-8-yl, 1,7-phenanthroline-9-yl, 1,7-phenanthroline-10-yl, 1,8-phenanthroline-2-yl, 1,8-phenanthroline-3-yl, 1,8-phenanthroline-4-yl, 1,8-phenanthroline-5-yl, 1,8-phenanthroline-6-yl, 1,8-phenanthroline-7-yl, 1,8-phenanthroline-9-yl, 1,8-phenanthroline-10-yl, 1,9-phenanthroline-2-yl, 1,9-phenanthroline-3-yl, 1,9-phenanthroline-4-yl, 1,9-phenanthroline-5-yl, 1,9-phenanthroline-6-yl, 1,9-phenanthroline-7-yl, 1,9-phenanthroline-8-yl, 1,9-phenanthroline-10-yl, 1,10-phenanthroline-2-yl, 1,10-phenanthroline-3-yl, 1,10-phenanthroline-4-yl, 1,10-phenanthroline-5-yl, 2,9-phenanthroline-1-yl, 2,9-phenanthroline-3-yl, 2,9-phenanthroline-4-yl, 2,9-phenanthroline-5-yl, 2,9-phenanthroline-6-yl, 2,9-phenanthroline-7-yl, 2,9-phenanthroline-8-yl, 2,9-phenanthroline-10-yl, 2,8-phenanthroline-1-yl, 2,8-phenanthroline-3-yl, 2,8-phenanthroline-4-yl, 2,8-phenanthroline-5-yl, 2,8-phenanthroline-6-yl, 2,8-phenanthroline-7-yl, 2,8-phenanthroline-9-yl, 2,8-phenanthroline-10-yl, 2,7-phenanthroline-1-yl, 2,7-phenanthroline-3-yl, 2,7-phenanthroline-4-yl, 2,7-phenanthroline-5-yl, 2,7-phenanthroline-6-yl, 2,7-phenanthroline-8-yl, 2,7-phenanthroline-9-yl, 2,7-phenanthroline-10-yl, 1-phenazinyl, 2-phenazinyl, 1-phenothiazinyl, 2-phenothiazinyl, 3-phenothiazinyl, 4-phenothiazinyl, 1-phenoxazinyl, 2-phenoxazinyl, 3-phenoxazinyl, 4-phenoxazinyl, 2-oxazolyl, 4-oxazolyl, 5-oxazolyl, 2-oxadiazolyl, 5-oxadiazolyl, 3-furazanyl, 2-thienyl, 3-thienyl, 2-methylpyrrole-1-yl, 2-methylpyrrole-3-yl, 2-methylpyrrole-4-yl, 2-methylpyrrole-5-yl, 3-methylpyrrole-1-yl, 3-methylpyrrole-2-yl, 3-methylpyrrole-4-yl, 3-methylpyrrole-5-yl, 2-t-butylpyrrole-4-yl, 3-(2-phenylpropyl)pyrrole-1-yl, 2-methyl-1-indolyl, 4-methyl-1-indolyl, 2-methyl-3-indolyl, 4-methyl-3-indolyl, 2-t-butyl 1-indolyl, 4-t-butyl 1-indolyl, 2-t-butyl 3-indolyl, and 4-t-butyl 3-indolyl groups.

The substituted or unsubstituted carboxyl groups with 1 to 50 carbon atoms are represented by -COOZ, and examples of Z include methyl, ethyl, propyl, isopropyl, n-butyl, s-butyl, isobutyl, t-butyl, n-pentyl, n-hexyl, n-heptyl, n-octyl, hydroxymethyl, 1-hydroxyethyl, 2-hydroxyethyl, 2-hydroxyisobutyl, 1,2-dihydroxyethyl, 1,3-dihydroxyisopropyl, 2,3-dihyroxy-t-butyl, 1,2,3-trihydroxypropyl, chloromethyl, 1-chloroethyl, 2-chloroethyl, 2-chloroisobutyl, 1,2-dichloroethyl, 1,3-dichloroisopropyl, 2,3-dichloro-t-butyl, 1,2,3-trichloropropyl, bromomethyl, 1-bromoethyl, 2-bromoethyl, 2-bromoisobutyl, 1,2-dibromoethyl, 1,3-dibromoisopropyl, 2,3-dibromo-t-butyl, 1,2,3-tribromopropyl, iodomethyl, 1-iodoethyl, 2-iodoethyl, 2-iodoisobutyl, 1,2-diiodoethyl, 1,3-diiodoisopropyl, 2,3-diiodo-t-butyl, 1,2,3-triiodopropyl, aminomethyl, 1-aminoethyl, 2-aminoethyl, 2-aminoisobutyl, 1,2-diaminoethyl, 1,3-diaminoisopropyl, 2,3-diamino-t-butyl, 1,2,3-triaminopropyl, cyanomethyl, 1-cyanoethyl, 2-cyanoethyl, 2-cyanoisobutyl, 1,2-dicyanoethyl, 1,3-dicyanoisopropyl, 2,3-dicyano-t-butyl, 1,2,3-tricyanopropyl, nitromethyl, 1-nitroethyl, 2-nitroethyl, 2-nitroisobutyl, 1,2-dinitroethyl, 1,3-dinitraisopropyl, 2,3-dinitro-t-butyl, and 1,2,3-trinitropropyl groups.

Examples of the substituted or unsubstituted styryl groups include 2-phenyl-1-vinyl, 2,2-diphenyl-1-vinyl, and 1,2,2-triphenyl-1-vinyl groups.

Examples of the halogen groups include fluorine, chlorine, bromine and iodine.

Specific examples of the above compounds are illustrated below.

Further, metallic complexes such as 8-hydroxyquinolinol aluminum complex, and heterocycle compounds such as 4,4'-bis(carbazole-9-yl)-1,1'-biphenyl are also suitable.

Specific examples of the above compounds are illustrated below.

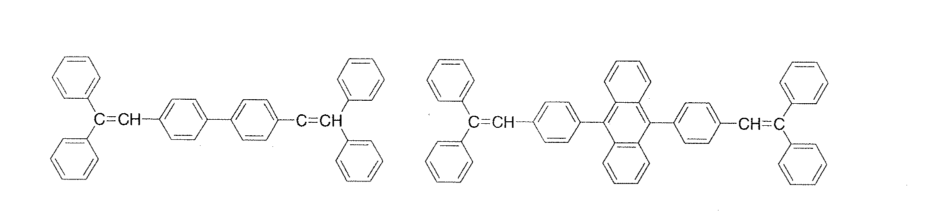

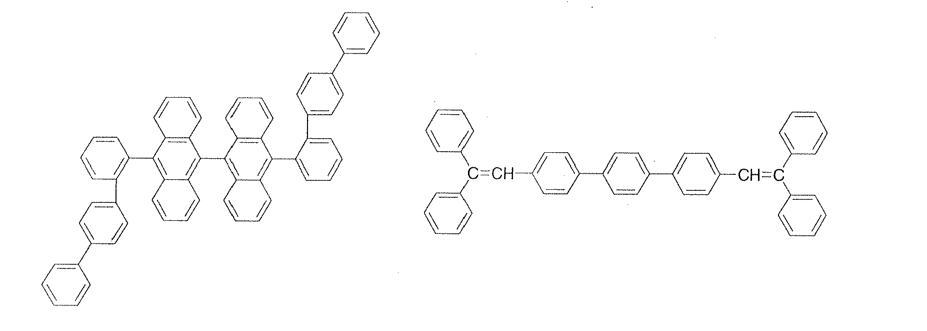

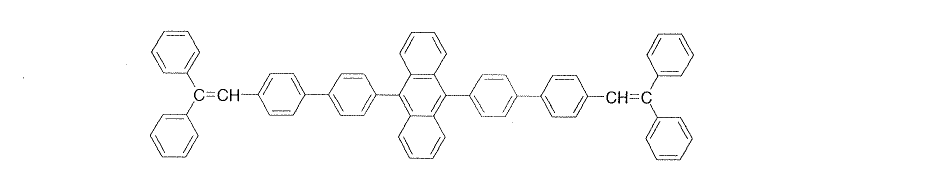

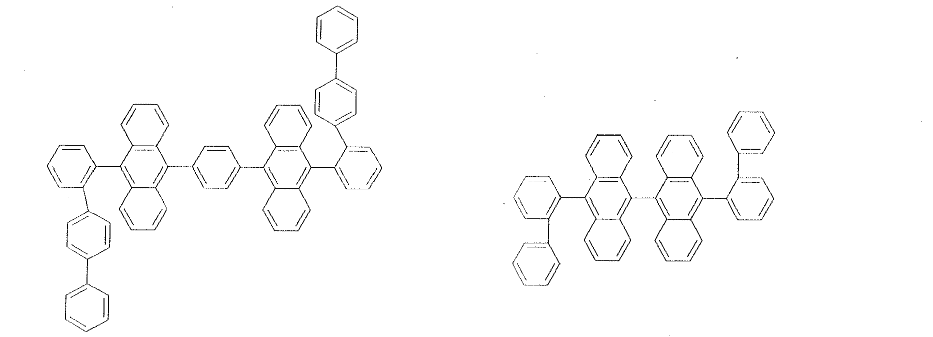

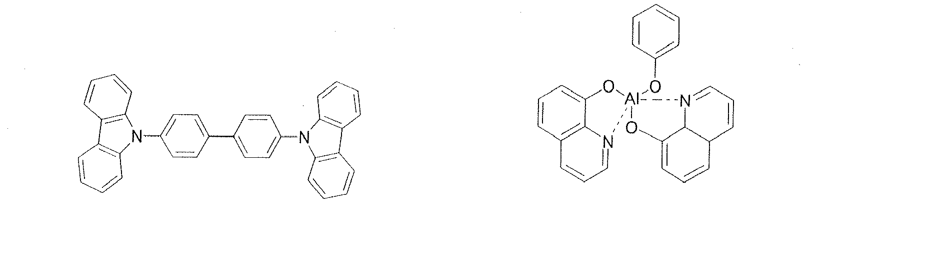

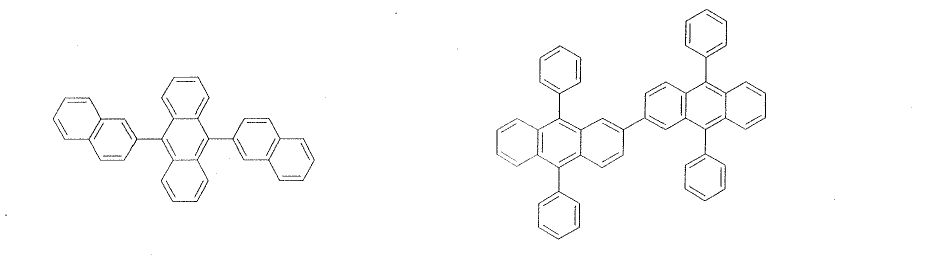

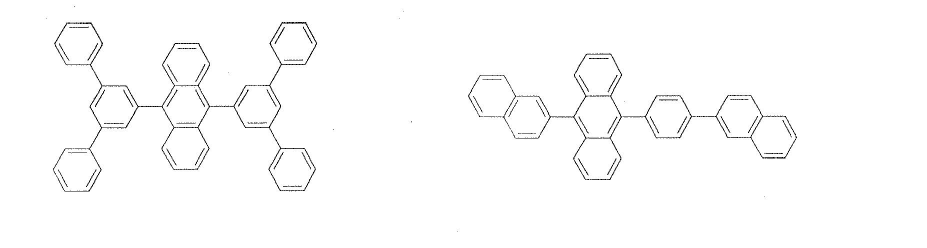

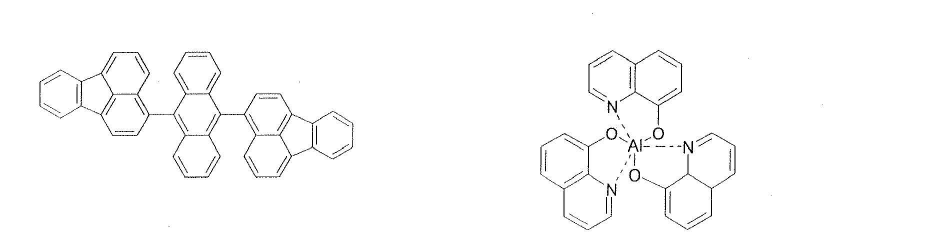

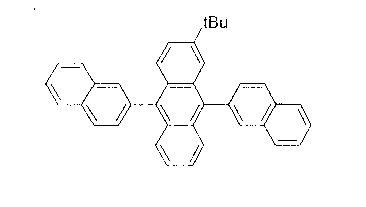

In the emitting layer, its emission capability can be improved by further adding a small amount of fluorescent compound as a dopant. The dopant may be a dopant known as a luminescent material having a long durability. It is preferred to use, as the dopant material of the luminescent material, a material represented by the formula [2]: 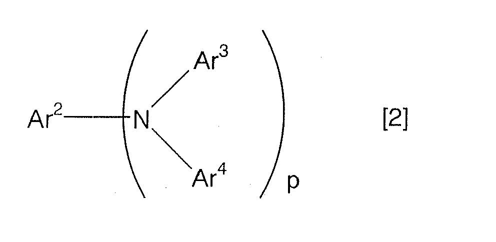
wherein Ar² to Ar⁴ are each a substituted or unsubstituted aromatic group with 6 to 50 nucleus carbon atoms, or a substituted or unsubstituted styryl group; and p is an integer of 1 to 4; provided that Ar³s, as well as Ar⁴s, may be the same as or different from each other when p is 2 or more.

Examples of the substituted or unsubstituted aromatic group with 6 to 50 nucleus carbon atoms include phenyl, 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 1-naphthacenyl, 2-naphthacenyl, 9-naphthacenyl, 1-pyrenyl, 2-pyrernyl, 4-pyrenyl, 2-biphenylyl, 3-biphenylyl, 4-biphenylyl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-t-butylphenyl, p-(2-phenylpropyl)phenyl, 3-methyl-2-naphthyl, 4-methyl-1-naphthyl, 4-methyl-1-anthryl, 4'-methylbiphenylyl, 4"-t-butyl-p-terphenyl-4-yl, 2-fluorenyl, 9,9-dimethyl-2-fluorenyl and 3-fluorantenyl groups.

Preferred examples thereof include phenyl, 1-naphthyl, 2-naphthyl, 9-phenanthryl, 1-naphthacenyl, 2-naphthacenyl, 9-naphthacenyl, 1-pyrenyl, 2-pyrenyl, 4-pyrenyl, 2-biphenylyl, 3-biphenylyl, 4-biphenylyl, o-tolyl, m-tolyl, p-tolyl, p-t-butylphenyl, 2-fluorenyl, 9,9-dimethyl-2-fluorenyl and 3-fluorantenyl groups.

Examples of the substituted or unsubstituted styryl group include 2-phenyl-1-vinyl, 2,2-diphenyl-1-vinyl, and 1,2,2-triphenyl-1-vinyl groups.

As other examples, condensed aromatic compounds such as rubrene, metallic complexes such as Ir(ppy)₃, and fluorescent dyes such as coumarin and DCJTB may be added.

Specific examples of the above compounds are illustrated below.

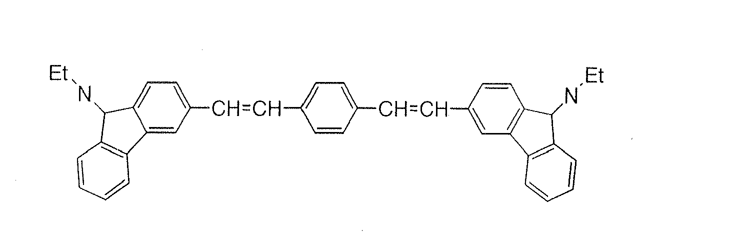

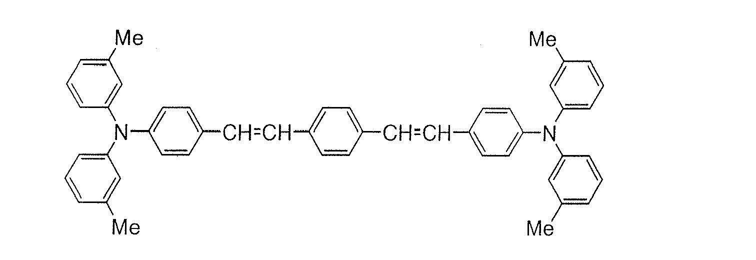

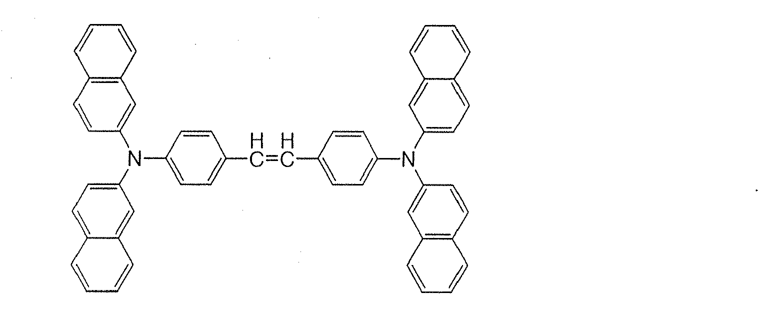

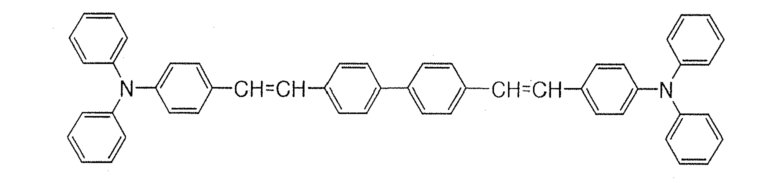

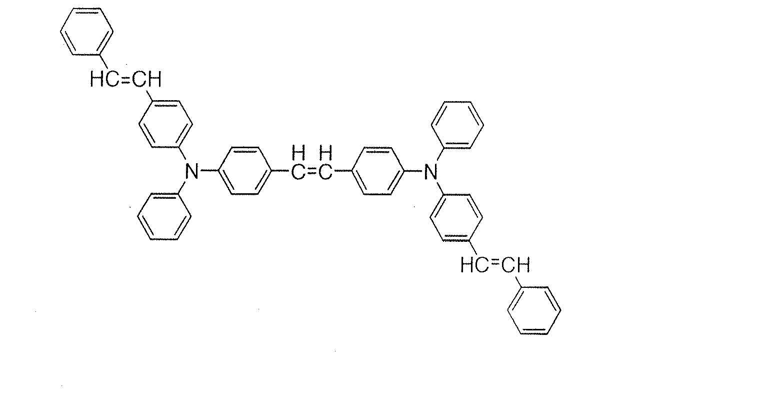

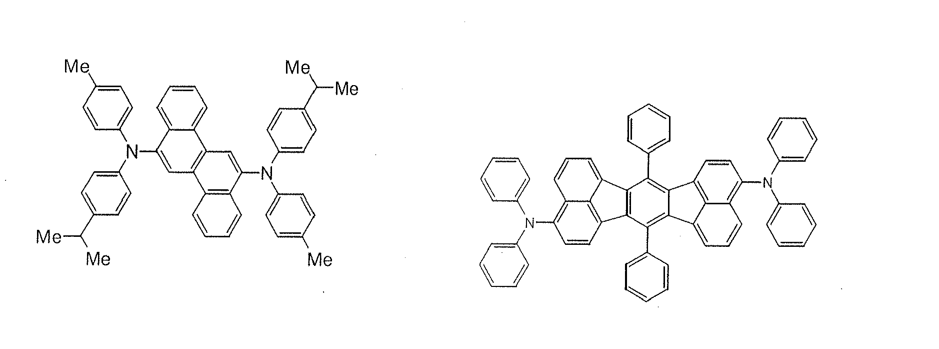

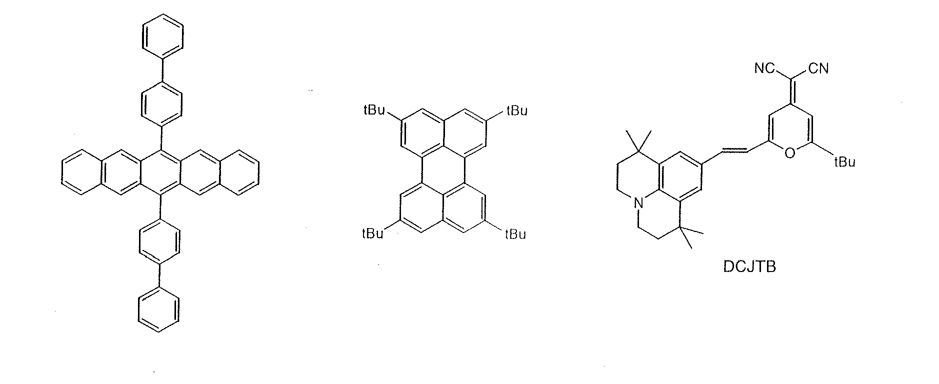

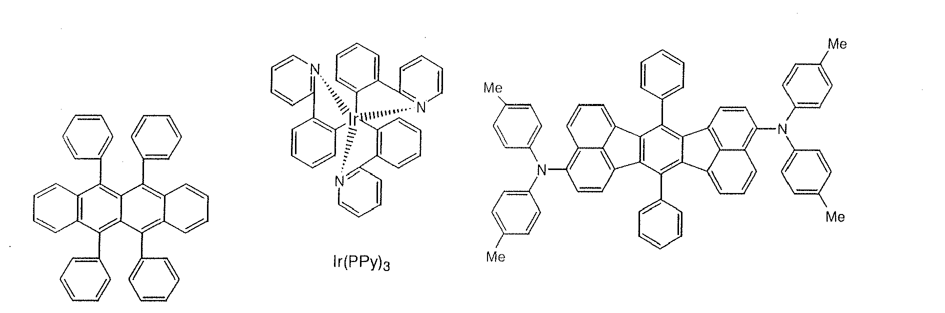

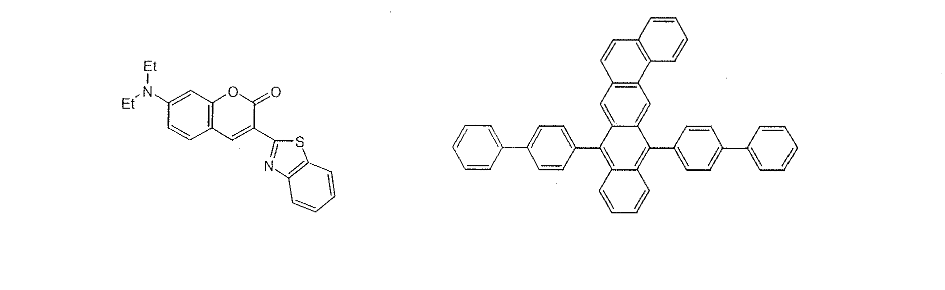

### (5) Hole-transporting Zone

A hole-transporting zone comprises at least one hole-transporting layer or a laminate of hole-transporting layers with an inorganic compound layer therebetween and, if necessary, a hole-injecting layer.

The hole-transporting layer is a layer for helping the injection of holes into the emitting layer so as to transport the holes to a light emitting region. The hole mobility thereof is large and the ionization energy thereof is usually as small as 5.5 eV or less. Such a hole-transporting layer is preferably made of a material that can transport holes to the emitting layer at a lower electric field intensity. The hole mobility thereof is preferably at least 10⁻⁴ cm²/V·second when an electric field of, e.g., 10⁴ to 10⁶ V/cm is applied.

The material for forming the hole-transporting layer is not particularly limited so long as the material has the above-mentioned preferred natures. The material can be arbitrarily selected from materials which have been widely used as a hole transporting material in photoconductive materials and known materials used in a hole injecting layer of organic EL devices.

Specific examples thereof include triazole derivatives (see USP No. 3,112,197 and others), oxadiazole derivatives (see USP No. 3,189,447 and others), imidazole derivatives (see JP-B-37-16096 and others), polyarylalkane derivatives (see USP Nos. 3,615,402, 3,820,989 and 3,542,544, JP-B-45-555 and 51-10983, JP-A-51-93224, 55-17105, 56-4148, 55-108667, 55-156953 and 56-36656, and others), pyrozoline derivatives and pyrozolone derivatives (see USP Nos. 3,180,729 and 4,278,746, JP-A-55-88064, 55-88065, 49-105537, 55-51086, 56-80051, 56-88141, 57-45545, 54-112637 and 55-74546, and others), phenylene diamine derivatives (see USP No. 3,615,404, JP-B-51-10105, 46-3712 and 47-25336, JP-A-54-53435, 54-110536 and 54-119925, and others), arylamine derivatives (see USP Nos. 3,567,450, 3,180,703, 3,240,597, 3,658,520, 4,232,103, 4,175,961 and 4,012,376, JP-B-49-35702 and 39-27577, JP-A-55-144250, 56-119132 and 56-22437, DE1,110,518, and others), amino-substituted chalcone derivatives (see USP No. 3,526,501, and others), oxazole derivatives (ones disclosed in USP No. 3,257,203, and others), styrylanthracene derivatives (see JP-A-56-46234, and others), fluorenone derivatives (JP-A-54-110837, and others), hydrazone derivatives (see USP Nos. 3,717,462, JP-A-54-59143, 55-52063, 55-52064, 55-46760, 55-85495, 57-11350, 57-148749 and 2-311591, and others), stylbene derivatives (see JP-A-61-210363, 61-228451, 61-14642, 61-72255, 62-47646, 62-36674, 62-10652, 62-30255, 60-93455, 60-94462, 60-174749 and 60-175052, and others), silazane derivatives (USP No. 4,950,950), polysilanes (JP-A-2-204996), aniline copolymers (JP-A-2-282263), and electroconductive macromolecular oligomers (in particular thiophene oligomers) disclosed in JP-A-1-211399.

In the hole-transporting zone, it is also possible to form a hole-injecting layer separately in order to further help hole injection. The same substances as those used for the above-mentioned hole-transporting layer can be used as the material of the hole-injecting layer. The following is preferably used: porphyrin compounds (disclosed in JP-A-63-2956965 and others), aromatic tertiary amine compounds and styrylamine compounds (see USP No. 4,127,412, JP-A-53-27033, 54-58445, 54-149634, 54-64299, 55-79450, 55-144250, 56-119132, 61-295558, 61-98353 and 63-295695, and others), in particular, the aromatic tertiary amine compounds.

The following can also be given as examples: 4,4'-bis(N-(1-naphthyl)-N-phenylamino)biphenyl (hereinafter referred to as NPD), which has in the molecule thereof two condensed aromatic rings, disclosed in USP No. 5,061,569, and 4,4',4"-tris(N-(3-methylphenyl)-N-phenylamino)triphenylamine (hereinafter referred to as hereinafter referred to as MTDATA), wherein three triphenylamine units are linked to each other in a star-burst form, disclosed in JP-A-4-308688.

Inorganic compounds, such as p-type Si and p-type SiC, as well as the aromatic dimethylidene type compounds can also be used as the material of the hole-injecting layer.

The hole-injecting and the hole-transporting layer can be formed by making the above-mentioned compound(s) into a thin film by a known method, such as vacuum deposition, spin coating, casting or LB technique. The thickness of hole-transporting layer is not particularly limited, and is usually from 5 nm to 5 µm. This hole-transporting layer may be a single layer made of one or more out of the above-mentioned materials. When a hole-transporting layer is formed of two or more layers, the layers can be made of different compounds from each other.

The organic semiconductor layer, which is also a hole-transporting layer, is a layer for helping the injection of holes or electrons into the emitting layer, and is preferably a layer having an electroconductivity of 10⁻¹⁰ S/cm or more. The material of such an organic semiconductor layer may be an electroconductive oligomer, such as thiophene-containing oligomer or arylamine-containing oligomer disclosed in JP-A-8-193191, an electroconductive dendrimer such as arylamine-containing dendrimer.

### (6) Electron-transporting Zone

An electron-transporting zone comprises at least one electron-transporting layer or a laminate of electron-transporting layers with an inorganic compound layer therebetween and, if necessary, an electron-injecting layer.

The electron-transporting layer is a layer for helping the injection of electrons into the emitting layer, and has a large electron mobility. The adhesion-improving layer is a layer made of a material particularly good in adhesion to the cathode among such electron transporting layers. The material used in the electron-transporting layer is preferably a metal complex of 8-hydroxyquinoline or a derivative thereof.

Specific examples of the above-mentioned metal complex of 8-hydroxyquinoline or its derivative include metal chelate oxynoid compounds each containing a chelate of oxine (generally, 8-quinolinol or 8-hydroxyquinoline).

For example, (8- quinolinolato) an aluminum complex (Alq) can be used in the electron-transporting layer.

Examples of the oxadiazole derivative include electron-transporting compounds represented by the following general formulas [3] to [5]: 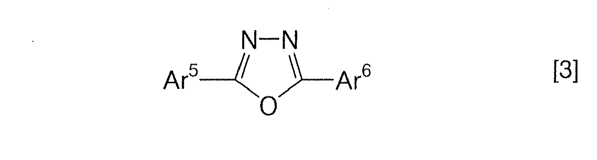 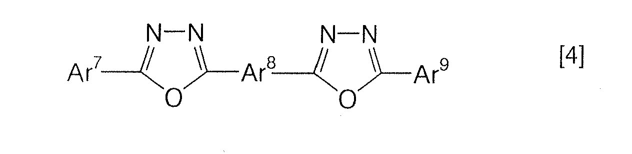 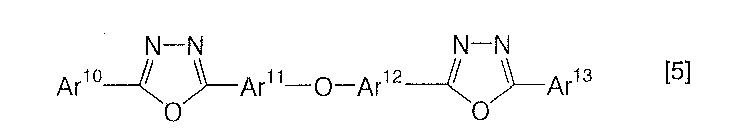
wherein Ar⁵, Ar⁶, Ar⁷, Ar⁹, Ar¹⁰ and Ar¹³ each represent a substituted or unsubstituted aryl group and may be the same as or different from each other, and Ar⁸, Ar¹¹ and Ar¹² represent substituted or unsubstituted arylene groups and may be the same as or different from each other.

Examples of the aryl group include phenyl, biphenyl, anthranyl, perylenyl, and pyrenyl groups. Examples of the arylene group include phenylene, naphthylene, biphenylene, anthranylene, perylenylene, and pyrenylene groups. Examples of the substituent include alkyl groups with 1 to 10 carbon atoms, alkoxy groups with 1 to 10 carbon atoms, and a cyano group. The electron-transporting compounds are preferably ones having capability of forming a thin film.

Specific examples of the electron-transporting compounds include the following:

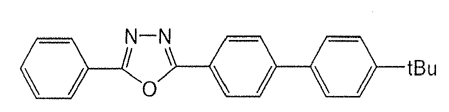

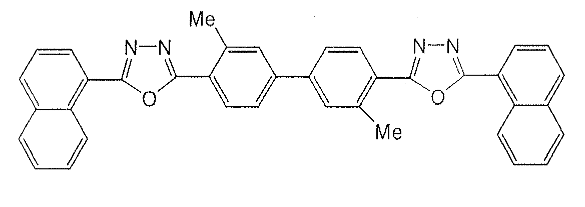

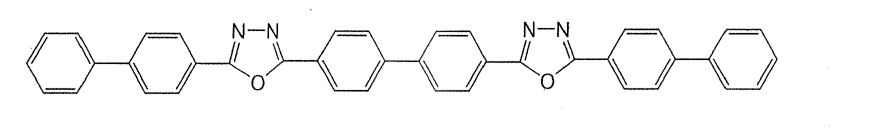

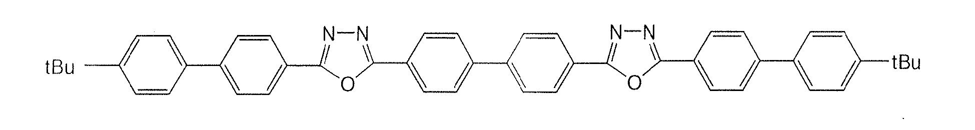

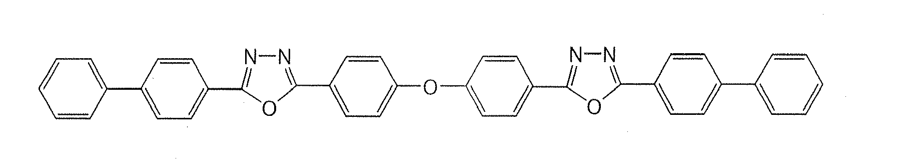

A preferred embodiment of the invention is an element comprising a reducing dopant in an interfacial region between its electron-transporting region or cathode and its organic layer. The reducing dopant is defined as a substance which can reduce an electron transporting compound. Accordingly, various substances which have given reducing properties can be used. For example, at least one substance can be preferably used which is selected from the group consisting of alkali metals, alkaline earth metals, rare earth metals, alkali metal oxides, alkali metal halides, alkaline earth metal oxides, alkaline earth metal halides, rare earth metal oxides, rare earth metal halides, alkali metal organic complexes, alkaline earth metal organic complexes, and rare earth metal organic complexes.

More specific examples of the preferred reducing dopants include at least one alkali metal selected from the group consisting of Na (work function: 2.36 eV), K (work function: 2.28 eV), Rb (work function: 2.16 eV) and Cs (work function: 1.95 eV), and at least one alkaline earth metal selected from the group consisting of Ca (work function: 2.9 eV), Sr (work function: 2.0 to 2.5 eV), and Ba (work function: 2.52 eV). Metals having a work function of 2.9 eV or less are in particular preferred. Among these, a more preferable reducing dopant is at least one alkali metal selected from the group consisting of K, Rb and Cs. Even more preferable is Rb or Cs. Most preferable is Cs. These alkali metals are particularly high in reducing ability. Thus, the addition of a relatively small amount thereof to an electron-injecting zone makes it possible to improve the luminance of the organic EL device and make the durability thereof long.

As the reducing dopant having a work function of 2.9 eV or less, any combination of two or more out of these alkali metals is also preferred. Particularly preferred is any combination containing Cs, for example, a combination of Cs and Na, Cs and K, Cs and Rb, or Cs, Na and K. The combination containing Cs makes it possible to exhibit the reducing ability efficiently. The luminance of the organic EL device can be improved and the durability thereof can be made long by the addition thereof to its electron-injecting zone.

In the invention, an electron-injecting layer made of an insulator or a semiconductor may be further formed between its cathode and organic layer. At this time, leakage of electric current is effectively prevented so that the electron injecting property can be improved. It is preferred to use, as such an insulator, at least one metal compound selected from the group consisting of alkali metal calcogenides, alkaline earth metal calcogenides, halides of alkali metals, and halides of alkaline earth metals. It is preferred that the electron injecting layer is made of one or more out of these alkali metal calcogenides and the like since the electron injecting property thereof can be further improved.

Specifically, preferred examples of the alkali metal calcogenides include Li₂O, LiO, Na₂S, Na₂Se and NaO. Preferred examples of the alkaline earth metal calcogenides include CaO, BaO, SrO, BeO, BaS, and CaSe. Preferred examples of the halides of alkali metals include LiF, NaF, KF, LiCl, KCl, and NaCl. Preferred examples of the halides of alkaline earth metals include fluorides such as CaF₂, BaF₂, SrF₂, MgF₂, and BeF₂; and halides other than fluorides.

Examples of the semiconductor constituting the electron-injecting layer may be one or any combination of two or more out of oxides, nitrides or oxynitrides containing at least one of Ba, Ca, Sr, Yb, Al, Ga, In, Li, Na, Cd, Mg, Si, Ta, Sb and Zn.

The inorganic compound constituting the electron-injecting layer preferably forms a microcrystalline or amorphous insulator thin film. If the electron-injecting layer is made of the insulator thin film, the thin film becomes a more homogenous thin film. Therefore, pixel defects such as dark spots can be decreased.

Examples of such an inorganic compound include the above-mentioned alkali metal calcogenides, alkaline earth metal calcogenides, halides of alkali metals, and halides of alkaline earth metals.

### (7) Cathode

For the cathode, the following may be used: an electrode substance made of a metal, an alloy or an electroconductive compound which has a small work function (4 eV or less), or a mixture thereof. Specific examples of the electrode substance include sodium, sodium-potassium alloy, magnesium, lithium, magnesium/silver alloy, aluminum/aluminum oxide, aluminum/lithium alloy, indium, and rare earth metals.

This cathode can be formed by making the electrode substance(s) into a thin film by vapor deposition, sputtering or some other method.

In the case where luminescence from the emitting layer is taken out through the cathode, it is preferred to make the transmittance of the cathode to the luminescence larger than 10%.

The sheet resistance of the cathode is preferably several hundreds Ω/ or less, and the film thickness thereof is usually from 10 nm to 1 µm, preferably from 50 to 200 nm.

### (8) Insulator Layer

In the organic EL device, pixel defects based on leakage or a short circuit are easily generated since an electric field is applied to the super thin film. In order to prevent this, it is preferred to insert an insulator thin layer between the pair of electrodes.

Examples of the material used in the insulator layer include aluminum oxide, lithium fluoride, lithium oxide, cesium fluoride, cesium oxide, magnesium oxide, magnesium fluoride, calcium oxide, calcium fluoride, aluminum nitride, titanium oxide, silicon oxide, germanium oxide, silicon nitride, boron nitride, molybdenum oxide, ruthenium oxide, and vanadium oxide.

A mixture or laminate thereof may be used.

### (9) Examples of forming Organic EL Device

The organic EL device can be produced by forming an anode, and an emitting layer, a hole-transporting layer and/or an electron-transporting layer as a charge-transporting layer, optionally forming a hole injecting layer and an electron injecting layer, and further forming a cathode by use of the materials and methods exemplified above. The organic EL device can be produced in the order reverse to the above, i.e., the order from a cathode to an anode.

An example of the production of the organic EL device will be described below which has a structure wherein the following are successively formed over a transparent substrate: anode/hole-transporting layer/emitting layer/electron-transporting layer/cathode (see figure 1).

First, a thin film made of an anode material is formed into a thickness of 1 µm or less, preferably 10 to 200 nm on an appropriate transparent substrate 11 by vapor deposition, sputtering or some other method, thereby forming an anode 12.

Next, a hole-transporting layer 13 is formed on this anode 12.

As described above, the hole-transporting layer 13 can be formed by vacuum deposition, spin coating, casting, LB technique, or some other method. Vacuum deposition is preferred since a homogenous film is easily obtained and pinholes are not easily generated. In the case where the hole-transporting layer 13 is formed by vacuum deposition, conditions for the deposition vary in accordance with the used compound (the material for the hole-transporting layer 13), the crystal structure or recombining structure of a hole-transporting layer 13 intended, and others. In general, the conditions are appropriately selected from the following: deposition source temperatures of 50 to 450°C, vacuum degrees of 10⁻⁷ to 10⁻³ torr, vapor deposition rates of 0.01 to 50 nm/second, substrate temperatures of -50 to 300°C, and film thicknesses of 5 nm to 5 µm.

An inorganic compound layer 17 is formed in a thickness of several nm to several tens nm on this hole-transporting layer 13. This inorganic compound layer 17 can be formed using various methods, specifically vacuum deposition, sputtering, electron beam deposition, etc. When the inorganic compound layer 17 is formed by vacuum deposition, the deposition conditions vary depending on a compound used (the material for the hole transporting layer), the crystal structure or the re-combining structure of a hole-transporting layer 13 intended, and others. In general, the conditions are appropriately selected from the following: deposition source temperatures of 500 to 1000 °C, vacuum degrees of 10⁻⁷ to 10⁻³ torr, vapor deposition rates of 0.01 to 50 nm/second, substrate temperatures of -50 to 300°C, and film thicknesses of 1 nm to 20 nm.

A hole-transporting layer 13 and an inorganic compound layer 17 are repeatedly formed to laminate hole-transporting layers 13. This allows the part formed of the hole-transporting layers 13 and the inorganic compound layer(s) 17 to be thicker up to several tens nm to several µm with the increase of driving voltage suppressed. There is no limitation particularly in the lamination time of hole-transporting layers 13, but 2 to 10 times are preferable.

Next, an emitting layer 14 is formed on a hole-transporting layer 13. The emitting layer 14 can be formed by making a thin film from a desired organic luminescent material by vacuum deposition, spattering, spin coating, casting and the like. Vacuum deposition is preferred since a homogenous film is easily obtained and pinholes are not easily generated. When the emitting layer 14 is formed using vacuum deposition, the deposition conditions vary depending on a compound used. In general, the conditions are appropriately selected from the same range as that described for the hole transporting layer 13.

Next, an electron-transporting layer 15 is formed on the emitting layer 14. It is preferably formed by vacuum deposition because a homogeneous film is required like the hole transporting layer 13 and the emitting layer 14. The deposition conditions can be selected from the same range as those of hole-transporting layer 13 and the emitting layer 14.

Like the hole-transporting layer 13, electron-transporting layers 15 can be stacked with an inorganic compound layer 17 interposed therebetween. By laminating the electron-transporting layers 15, the part formed of the electron-transporting layers 15 and the inorganic compound layer(s) 17 can be thicker up to several tens nm to several µm. There is no limitation particularly in the lamination time of electron-transporting layer 15, but 2-10 times are preferable.

Lastly, laminating a cathode 16 can produce an organic EL device 1. The cathode 16 is formed of a metal, and deposition and spattering can be used. In order to protect the under organic layers from damage during the film forming process, vacuum deposition is preferred.

It is preferable that the above organic EL device 1 is formed by one vacuuming throughout from the anode to the cathode.

The method for forming each of the layers in the organic EL device of the invention is not particularly limited. A forming method known, such as vacuum deposition or spin coating, can be used. For example, they can be formed by known ways such as vacuum deposition, molecular beam deposition (MBE method), or application of a solution in which a material is dissolved in a solvent such as dipping, spin coating, casting, bar coating or roll coating.

The thickness of each of the organic layers in the organic EL device of the invention is not particularly limited. In general, defects such as pinholes are easily generated when the film thickness is too small. Conversely, a high applied voltage becomes necessary and the efficiency falls when the film thickness is too large. Usually, therefore, the film thickness is preferably in the range of several nanometers to one micrometer.

In the case where a DC voltage is applied to the organic EL device, luminescence can be observed when the polarity of the anode and that of the cathode are made positive and negative, respectively, and the voltage of 5 to 40 V is applied. Even if a voltage is applied thereto in the state that the polarities are reverse to the above, no electric current flows so that luminescence is not generated at all. In the case where an AC voltage is applied thereto, uniform luminescence can be observed only when the polarity of the anode and that of the cathode are made positive and negative, respectively. The waveform of the AC to be applied may be arbitrarily selected.

### [Examples]

Examples of the invention will be described in detail hereinafter. However, the invention is not limited to these examples.

Compounds used in the examples are illustrated below.

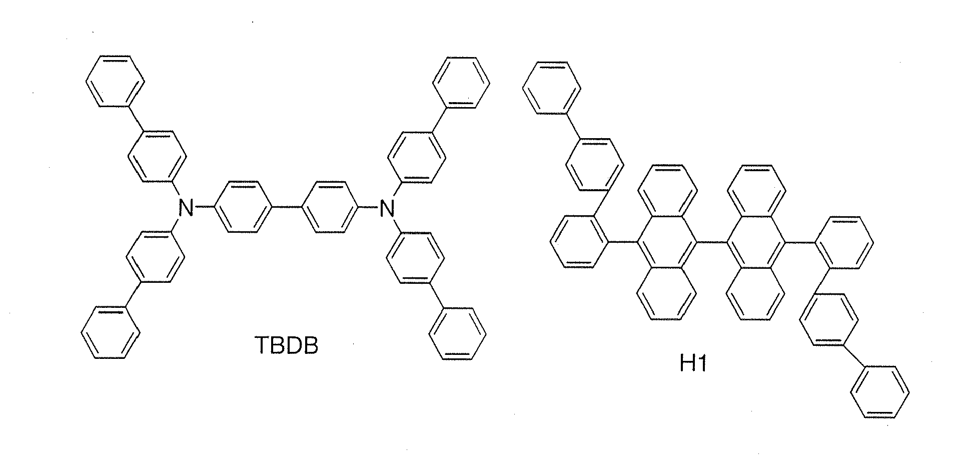

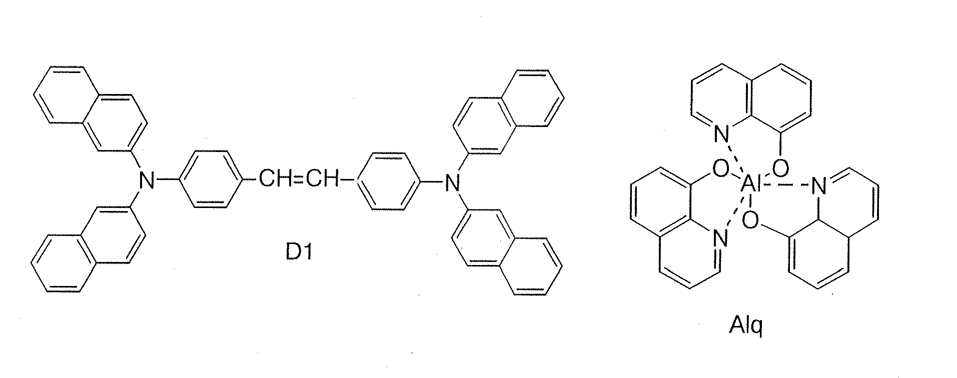

### Example 1

A glass substrate, 25 mm x 75 mm x 1.1 mm thick, having an ITO transparent electrode lines (manufactured by Geomatics Co.) was subjected to ultrasonic cleaning in isopropyl alcohol for 5 minutes followed by UV ozone cleaning for 30 minutes.

The washed glass substrate having the transparent electrode lines was set up on a substrate holder in a vacuum deposition device. First, an N,N,N',N'-tetra(4-biphenyl)-diaminobiphenylene layer (TBDB layer hereinafter) was formed into a film in thickness of 60 nm on the surface on which the transparent electrode lines were formed, so as to cover the transparent electrode. This film functions as a hole-transporting layer.

Following the TBDB film formation, molybdenum trioxide and cesium (Cs source: Saesgetter Co.) were co-deposited in a thickness of 10 nm on this TBDB film, using a resistant heating board. The deposition ratio was cesium 0.1 nm to molybdenum trioxide 10 nm in film thickness. This film functions as an inorganic compound layer.

A TBDB layer was similarly deposited in a thickness of 60 nm thereon.

Next, a host H1 was deposited to form a 40 nm thick film on the TBDB layer. At the same time, as a luminescent molecule, a dopant D1 was co-deposited. The deposition ratio this time was H1:D1= 20:1 (weight ratio). This film functions as an emitting layer.

Further, Alq was deposited to form a 20 nm thick film. This film functions as an electron-transporting layer.

Thereafter, LiF was deposited in a thickness of 1 nm as an insulating layer.

Lastly, metal Al was deposited to a 150 nm thickness as a metal cathode, thereby forming an organic EL device.

The driving voltage of this organic EL device in a luminance of 1,000-nit emission and the half life thereof in the initial luminance (L0) of 1,000-nit were measured.

After storing this organic EL device at 105°C for 100 hours, the temperature was returned to room temperature and checked for current leakage.

The current leakage was checked by applying voltage in reverse polarity. Specifically, 5V was applied in reverse polarity to evaluate if the current leaked or not.

Table 1 indicates the measurement results of Example 1, and Example 2 and Comparative Examples 1-3 described later.

**Table 1**

| | Driving voltage (@1,000nit) | Half life (L0=1,000nit) | Leakage |
|---|---|---|---|
| Example 1 | 5.8V | 1,500h | No leakage |
| Comparative Example 1 | 7.5V | 1,400h | No leakage |
| Example 2 | 6.3V | 1,300h | No leakage |
| Comparative Example 2 | 7.8V | 1,300h | No leakage |
| Comparative Example 3 | 6.6V | 1,600h | Leakage |

### Comparative Example 1

An organic EL device was formed in the same manner as in Example 1 except that an inorganic compound layer is not formed.

This organic EL device was evaluated in the same way as in Example 1.

### Example 2

A grass substrate with ITO transparent electrode lines was cleaned in the same way as in Example 1. A TBDB layer was formed in a thickness of 60 nm on the surface of the substrate with the transparent electrode thereon so as to cover the transparent electrode. This film functions as a hole-transporting layer.

On this TBDB layer, H1 was deposited to form a 40 nm thick film. At the same time, a dopant D1 was co-deposited as a luminescent molecular. The deposition ratio was H1:D1=20:1 (weight ratio). This film functions as an emitting layer.

Alq was deposited to form a 20 nm thick film. This film functions as an electron-transporting layer.

Following the Alq film formation, using a resistance heating board, molybdenum trioxide and cesium fluoride were co-deposited in a thickness of 10 nm on the Alq film. The deposition ratio of cesium fluoride to molybdenum trioxide was 0.1 nm to 10 nm. This film functions as an inorganic compound layer.

Further, Alq was deposited to form a 20 nm thick film on the inorganic compound layer. An insulating layer and a metal cathode were formed in the same way as in Example 1, thereby forming an organic EL device.

This organic EL device was evaluated in the same way as in Example 1.

### Comparative Example 2

An organic EL device was formed in the same manner as in Example 2 except that an inorganic compound layer is not formed. This organic EL device was evaluated in the same way as in Example 1.

### Comparative Example 3

An organic EL device was formed in the same manner as in Comparative Example 1 except that only one TBDB layer was formed and the thickness thereof was 60 nm. This organic EL device was evaluated in the same way as in Example 1.

From the above measurement results, regardless of the presence of an inorganic compound layer, there was not a difference in half life; however, in the elements where an inorganic compound layer was formed, the driving voltage decreased nevertheless the thick thickness thereof.

When the organic EL devices were checked for leakage after storing for 100 hours in 105°C, leakage occurred in the element of Comparative Example 3 where the hole transporting layer was thin.

### Industrial Applicability

The invention provides an organic EL device that can be driven with a low voltage although it is of thick thickness structure.

## Claims

1. An organic electroluminescent device comprising:
a pair of electrodes being an anode and a cathode,
an emitting layer comprising an organic compound, the layer being interposed between the electrodes, and
charge-transporting layers comprising an organic compound between at least one of the anode and the cathode, and the emitting layer,
the charge-transporting layers being stacked with an inorganic compound layer interposed therebetween.

2. The organic electroluminescent device according to claim 1, wherein hole-transporting layers exist as the charge-transporting layer between the anode and the emitting layer, and
the hole-transporting layers are stacked with the inorganic compound layer interposed therebetween.

3. The organic electroluminescent device according to claim 1, wherein electron-transporting layers exist as the charge-transporting layer between the cathode and the emitting layer, and
the electron-transporting layers are stacked with the inorganic compound layer interposed therebetween.

4. The organic electroluminescent device according to claim 1, wherein the inorganic compound layer comprises at least one of elements belonging to the third group to the twelfth group of the periodic system.

5. The organic electroluminescent device according to claim 4, wherein the inorganic compound layer between hole-transporting layers further comprises at least one of elements belonging to the first group or the second group of the periodic system.

6. A display comprising a display screen formed by comprising the organic electroluminescent device of claim 1.
